Europäisches Patentamt

European Patent Office

Office européen des brevets

(11) Veröffentlichungsnummer : **0 222 737 B1**

## (12) EUROPÄISCHE PATENTSCHRIFT

(45) Veröffentlichungstag der Patentschrift :
**12.10.94 Patentblatt 94/41**

(21) Anmeldenummer : **86890315.4**

(22) Anmeldetag : **13.11.86**

(51) Int. Cl.⁵ : **G03F 1/00**

(54) Verfahren zum Stabilisieren von aus einer Maskenfolie und einem Halterahmen für diese Folie bestehenden Masken.

(30) Priorität : **13.11.85 AT 3311/85**

(43) Veröffentlichungstag der Anmeldung :
**20.05.87 Patentblatt 87/21**

(45) Bekanntmachung des Hinweises auf die
Patenterteilung :
**12.10.94 Patentblatt 94/41**

(84) Benannte Vertragsstaaten :
**AT BE DE FR GB IT NL SE**

(56) Entgegenhaltungen :
**AT-A- 383 438
DE-A- 3 213 239
GB-A- 2 067 785
PATENT ABSTRACTS OF JAPAN, Band 4, Nr.
82 (P-15)[564], 13. Juni 1980 ; & JP-A-55 46 758**

(73) Patentinhaber : **IMS Ionen Mikrofabrikations
Systeme Gesellschaft m.b.H.
Schreygasse 3
A-1020 Wien (AT)**
Patentinhaber : **Österreichische
Investitionskredit Aktiengesellschaft
Renngasse 10
A-1013 Wien (AT)**

(72) Erfinder : **Löschner, Hans, Dr.
Vegagasse 6/2
A-1190 Wien (AT)**
Erfinder : **Stengl, Gerhard, Dr.
Hammergasse 11
A-9500 Villach Kärnten (AT)**

(74) Vertreter : **Matschnig, Franz, Dipl.-Ing.
Siebensterngasse 54
Postfach 252
A-1070 Wien (AT)**

**Beschreibung**

Die Erfindung betrifft ein Verfahren zum Stabilisieren einer aus einer Maskenfolie und einer, annähernd gleichen thermischen Ausdehnungskoeffizient wie diese besitzenden, rahmenartigen Halterung für diese Folie bestehenden Maske, die in einem Abbildungsgerät, im Betrieb abgebildet und dabei einer Wärmebeanspruchung durch ein Abbildungsmedium, z.B. Ionen-, Elektronen- oder Röntgenstrahlen, ausgesetzt wird, wobei die Maskenfolie für das Abbildungsmedium durchlässige Bereiche besitzt.

Zur Stabilisierung von Maskenfolien unter permanenter Belastung wurden Verfahren zur thermischen Vorspannung von Maskenfolien realisiert. Dabei wird die Maskenfolie mit einem bevorzugt metallischen Maskenrahmen bei einer geeigneten Temperatur verbunden. Ist der thermische Ausdehnungskoeffizient des Maskenrahmens geringer als jener der Maskenfolie, so erfolgt nach einem nicht zum Stand der Technik gehörenden Vorschlag die Verankerung der Maskenfolie in dem Rahmen bei erhöhter Temperatur, z.B. die Verankerung einer Maskenfolie aus Nickel in einem INVAR-Rahmen bei 60°. Im umgekehrten Fall erfolgt das Festklemmen, z.B. einer Nickelmaskenfolie in einem Aluminiumrahmen, bei niedriger Temperatur, z.B. bei -20°C. Nach dem Abkühlen auf Raumtemperatur bzw. nach dem Aufwärmen auf Raumtemperatur ist die Maskenfolie im Rahmen vorgespannt. Bei Belastung einer solcherart thermisch vorgespannten Maskenfolie durch das Abbildungsmedium bleibt die Lage der Strukturen in der Maskenfolie innerhalb eines durch den Temperaturhub definierten Belastungsbereiches unverändert, da durch die Strahlenbelastung lediglich das Ausmaß der thermischen Vorspannung verringert wird. Nachteilig ist jedoch, daß bereits durch das thermische Vorspannen der Maskenfolie durchaus erhebliche Verzerrungen in der Maskenfolie generiert werden können, insbes. dann, wenn die Maskenfolie nicht an allen Stellen dieselbe effektive Dicke aufweist. So führt insbes. das Vorspannen von Maskenfolien einheitlicher Dicke, die Öffnungen in der Folie besitzen, zu Verzerrungen, sodaß die Methode der thermischen Vorspannung insbes. in Anwendung bei der 1 : 1 Ionen- oder Elektronenschattenbelichtung bzw. bei der verkleinernden Ionen- oder Elektronenprojektion im allgemeinen nur für Testmasken angewendet werden kann.

Durch die GB-2067785 A wurde ein Verfahren zur Herstellung einer selbsttragenden Maske bekannt. Die Maske gemäß dem letztgenannten Dokument ist relativ stark vorgespannt, und damit nicht streßfrei, wobei der Grad der Vorspannung nur durch die Elastizitätsgrenze der Maskenfolie beschränkt wird. Eine eventuelle Heizung des Rahmens dient gemäß dem Bekannten dazu, die Rahmentemperatur konstant zu halten, wobei eine Blende verhindert, daß der Rahmen vom Abbildungsmedium getroffen wird. Eine über das Abbildungsmedium indirekt erfolgende Änderung der Rahmendimension wird dadurch verhindert; die Größe der Maske ändert sich dort also nicht.

Wohl wird gemäß dem britischen Dokument erreicht, daß sich die Maske im Betrieb nicht verformt, also nicht "durchhängt"; doch ergibt sich beim bekannten Verfahren, daß durch die Vorspannung die Strukturen der Maske verzerrt sind, also die Maske und demnach auch ihr Abbild nicht design-getreu bleibt. Nach dem bekannten Verfahren soll eine Maske erhalten werden, deren Strukturen zwar je nach ihrer Größe und Lage zueinander mehr oder minder verzerrt sind, deren Form und Größe sich jedoch während der Abbildung nicht verändert, also verzerrt bleibt. Dies ist entweder nur für Testmasken zulässig, oder es wird beim Design bereits die Verzerrung durch die Vorspannung berücksichtigt und entsprechend kompensiert, was jedoch aufwendig und von den Anwendern unerwünscht ist.

Aufgabe der Erfindung ist es, eine Stabilisierung von Masken unter einer erheblich höheren Belastung durch das Abbildungsmedium zu ermöglichen, als dies bisnun bei thermisch vorgespannten Masken möglich ist und gleichzeitig auch Verzerrungen intolerablen Ausmaßes, auch wenn Masken mit Strukturöffnungen verwendet werden, zu vermeiden. Erreicht wird dies dadurch, daß gemäß der Erfindung die Maskenfolie in der rahmenartigen Halterung stets spannungsfrei oder mit einer so geringen Vorspannung gehalten wird, daß durch die Vorspannung verursachte Verzerrungen von Strukturen in oder auf der Maskenfolie für den Abbildungsprozeß vernachlässigbar sind, daß die Maskenfolie mit ihrer rahmenartigen Halterung in einem im Abbildungsgerät befindlichen Klemmrahmen geklemmt wird und daß im Betrieb des Abbildungsgerätes, also bei Erwärmung durch das Abbildungsmedium dieser Klemmrahmen auf eine Temperatur erhitzt wird, welche die jeweilige Temperatur, die die Maskenfolie im Betrieb des Abbildungsgerätes annimmt, übersteigt und daduch auch die rahmenartige Halterung auf diese Temperatur erhitzt wird, wobei das Übersteigen der Temperatur des Klemmrahmens über jene der Maskenfolie nachgeregelt wird und jeweils nur soviel ausmacht, daß die Maskenfolie auch bei Erwärmung plan und damit verzerrungsfrei bleibt, ohne daß unerwünscht hohe Spannungen auftreten. Die Maskenfolie kann dabei über den Herstellungsprozeß mit einem Verankerungsrahmen verbunden sein. Durch technologische Methoden wird gewährleistet, daß die Maskenfolie nur eine geringe Spannung aufweist, daß damit verbundene Verzerrungen von Strukturen in oder auf der Maskenfolie für den Übertragungsprozeß vernachlässigbar sind. Als Material für den Verankerungsrahmen kommt aus herstellungstechnischen Gründen vor allem Silizium oder Glas in Frage.

Methoden zur Herstellung von weitgehend streßfreien Maskenfolien aus Silizium (mit Bor und Germanium dotiert) oder aus Siliziumnitrid, und deren Verankerung mit einem Rahmen aus Silizium sind Stand der Technik. Dabei ist der thermische Ausdehnungskoeffizient des Verankerungsrahmens durchaus gleich oder ähnlich jenem der Maskenfolie. Die erfindungsgemäße Stabilisierungsmethode wird durch einen derartigen Umstand sogar begünstigt. Der durch Anwendung des erfindungsgemäßen Verfahrens erzielbare Effekt basiert darauf, daß der durch die Erwärmung bedingten Ausdehnung der Maskenfolie kein Widerstand entgegengesetzt wird und somit die Maskenfolie nicht nur plan bleibt, sondern auch alle Strukturen der Maskenfolie mit linearer Ausdehnung vergrößert werden, sodaß die von Anfang an nur geringe Verzerrung der Maskenstrukturen keine Vergrößerung erfährt. Das erfindungsgemäße Verfahren bewirkt, daß über den Klemmrahmen, der mit der Halterung der Maskenfolie in Kontakt steht, die Halterung der Maskenfolie gesteuert erwärmt wird und somit die durch das Abbildungsmedium erwärmte Maskenfolie, die durch die Erwärmung bedingte jeweilige Größe, unbehindert annehmen kann. Auf diese Weise kann eine vollkommen streßfreie Maske auch unter hoher Belastung durch das Abbildungsmedium realisiert werden.

Bevorzugt wird vor dem Betrieb, also vor der Erwärmung durch das Abbildungsmedium die Vorspannung der Maskenfolie in der rahmenartigen Halterung entsprechend einer Dehnung von $10^{-5}$ bis $10^{-6}$ gehalten. Dadurch kann bei der Übertragung der Strukturen der Maske mit nur geringen Verzerrungen, die vernachlässigbar sind, gerechnet werden. Im Betrieb wird die rahmenartige Halterung um typisch 10° höher erwärmt als notwendig ist, um die Maskenfolie gerade planar zu erhalten. Auf diese Weise wird eine sehr geringe Spannung in der Maskenfolie generiert, sodaß einerseits mechanische Vibrationen nicht auf die streßfreie Maske übertragbar sind und anderseits Schwankungen in der Belastung der Maskenfolie durch das Abbildungsmedium zugelassen werden können.

Um die Maskenfolie gegen eine plastische Verformung durch einen Temperatursturz bei Ausbleiben des Abbildungsmediums zu sichern, wird in weiterer Ausgestaltung der Erfindung vorgeschlagen, daß bei Ausfall des Abbildungsmediums, die Maskenfolie durch Zufuhr eines Heizmediums aus einer zusätzlichen Wärmequelle, auf eine Temperatur gebracht wird, die mindestens gleich der Temperatur der Maskenfolie zum Zeitpunkt des Ausfalles des Abbildungsmediums ist, wobei das Heizmedium abhängig vom Temperaturabfall aktiviert wird. Das Heizmedium kann dabei an einer Infrarotquelle oder einer anderen Korpuskularstrahlenquelle emittiert werden. Soferne unter der Heizwirkung dabei die Maskenfolie durchhängt, ist dies für die weitere Verwendung der Folie ohne Bedeutung, da nach einer Temperatursenkung, die Folie sich wieder spannt. Die Messung der Maskentemperatur kann auf pyrometrischem Weg erfolgen. Bei Temperaturabfall wird dann die zusätzliche Wärmequelle eingeschaltet. Es kann die zusätzliche Quelle auch im Dauerbetrieb arbeiten, jedoch mit verminderter Intensität, wobei dann bei Ausfall des Abbildungsmediums die Intensität entsprechend erhöht wird.

Die Erfindung wird nachstehend unter Bezugnahme auf die Zeichnung näher erläutert. Es zeigen,

Fig. 1 in einem Querschnitt ein Detail eines Ahbbildungsgerätes, aus dem die Halterung der Maske ersichtlich ist,

Fig. 2 schematisch einen Längsschnitt durch ein Detail eines Abbildungsgerätes, mit durchhängender Maskenfolie und

Fig. 3 eine der Fig. 2 entsprechende Darstellung mit gespannter Maskenfolie.

In der Zeichnung ist mit 1 eine Maskenfolie bezeichnet, die mit einem Rahmen 2, z.B. aus Silizium, verankert ist. Die Stärke der Maskenfolie 1 beträgt 1 bis 5 μm. Die Maskenfolie 1 wird zur Bildung einer Maske bevorzugt gemeinsam mit dem Verankerungsrahmen 2 in einem Halterahmen gehalten, der aus einem Oberrahmen 3 und einem Unterrahmen 4 besteht. Zwischen dem Oberrahmen 3 und der Folie 1, vor allem jedoch zwischen dem Verankerungsrahmen 2 und dem Unterrahmen 4 können gut wärmeleitende elastische Schichten 8, 9, z.B. aus einem Elastomer angeordnet werden. Die elastische Schicht bildet beim Zusammenspannen von Oberrahmen 3 und Unterrahmen 4 einen Schutz für die Folie 1 und den Verankerungsrahmen 2, der häufig aus sprödem Material besteht, gegen Bruch und gleicht dabei Unebenheiten des Verankerungsrahmens aus. Die Maskenfolie 1 ist im Halterahmen 3, 4 spannungsfrei oder mit bloß geringer Vorspannung gehalten. Oberrahmen 3 und Unterrahmen 4 können durch Schrauben 5 miteinander verbunden werden. Im dargestellten Ausführungsbeispiel wird die Halterung für die Maskenfolie 1 vom Verankerungsrahmen 2 und dem Halterahmen, bestehend aus Oberrahmen 3 und Unterrahmen 4, gebildet. Die Halterung kann jedoch auch nur vom Verankerungsrahmen 2 gebildet werden. Der Halterahmen erleichtert allerdings die Handhabung der Maske. Die Maskenfolie 1 kann dabei so vorgespannt sein, daß ihre Dehnung $\frac{\Delta 1}{l_o}$ zwischen $10^{-5}$ und $10^{-6}$ liegt. Mit $\Delta 1$ ist dabei die Längenänderung gegenüber der Ausgangslänge $l_o$ bezeichnet, wobei die Ausgangslänge $l_o$ der Länge bei einer Bezugstemperatur, z.B. der Raumtemperatur entspricht. Bei einem Maskendurchmesser von 50 mm ergibt sich eine Vordehnung von ca. 0,5 μm über den planaren Zustand hinaus. Der Halterahmen 3, 4 aus gut wärmeleitendem Werkstoff wird in der Abbildungsvorrichtung zwischen scheibenartigen Backen 6, 7 eines Klemmrahmens gehalten. Zwischen den Backen 6, 7 und dem Halterahmen 3, 4 kann ebenfalls eine gut wärmeleitende elastische Schicht 8, 9, z.B. aus einem Elastomer, angeordnet werden. Die Backen 6, 7 aus gut wärmeleitendem Material können mit Kanälen 10 versehen sein, durch die ein Heiz- - bei Bedarf auch ein Kühlmedium - hindurchgeleitet werden kann. Ebenso könnten Heizdrähte, gegebenenfalls zusätzlich zu den Kanälen 10 in den Backen 6, 7 des Klemmrahmens vorgesehen werden. Die Maskenfolie 1 und der Halterahmen 3, 4 besitzen bevorzugt annähernd gleichen Ausdehnungskoeffizienten. Im Betrieb, d.h. bei Einwirkung des Abbildungsmediums auf die Maskenfolie 1 wird der Rahmen 3, 4 bzw. werden die Klemmbacken 6, 7 auf eine die Temperatur der Maskenfolie 1 übersteigende Temperatur erhitzt, z.B. durch Hindurchleiten eines entsprechend erhitzten Wärmeträgers durch die Kanäle 10 der Backen 6, 7 bzw. durch Anschluß der in die Backen 6, 7 eingebauten Heizdrähte an eine elektrische Energieversorgung. In einem Ionenprojektor sind Betriebstemperaturen von 100 - 200°C üblich. Geht man etwa von einer Arbeitstemperatur von 100°C aus, so wird der Rahmen 3, 4 bzw. werden die Klemmbacken 6, 7 auf eine Temperatur von beispielsweise 110° aufgeheizt. Bei einem INVAR-Rahmen, der eine Maskenfolie von 50 mm Durchmesser hält, bedeutet dies beispielsweise eine Vergrößerung von 0,5 um.

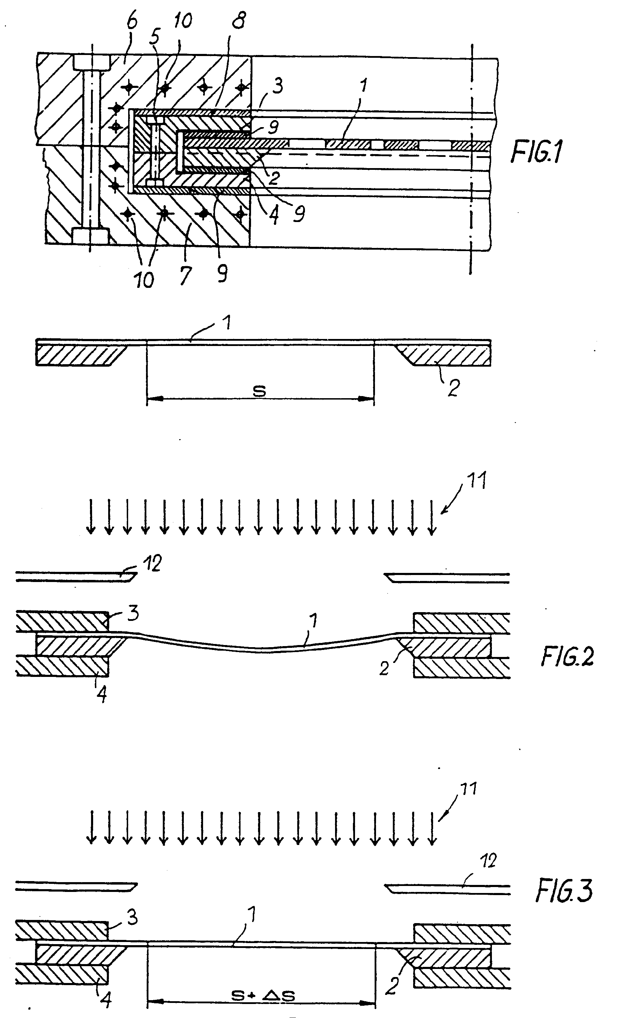

Aus den Fig. 2 und 3 werden die Verhältnisse klar, die sich beim Betrieb einer Maske in einem Projektionsgerät einstellen, u.zw. in Fig. 2 bei einem Betrieb, bei dem eine Erhitzung des Halterahmens 3, 4 nicht vorgesehen ist und in Fig. 3 mit Erhitzung des Halterahmens 3, 4 über die Temperatur der Maskenfolie 1.

Im oberen Teil der Fig. 2 ist dabei eine Maske, bestehend der Maskenfolie 1 und dem Verankerungsrahmen 2 gezeigt. Auf der Maskenfolie ist eine Strecke s eingezeichnet. Wird die Maske nun durch einen Ionenstrom 11 erhitzt, der - bedingt durch die Anordnung der Apertur 12 - nur die Maskenfolie 1 trifft, so dehnt sich die Maske und hängt durch. Dies führt zu Verzerrungen der Abbildung. Um dies auszuschalten, wird der Rahmen 3, 4 über die Temperatur der Maskenfolie 1 erhitzt, wodurch die Folie 1 gespannt wird. Die Strecke s hat sich dabei um Δs verlängert. Diese Verlängerung kann durch Änderung des Abbildungsverhältnisses - soweit überhaupt erforderlich - optisch korrigiert werden. Verzerrungen, wie sie beim Durchhängen der Maskenfolie auftreten, sind ausgeschlossen, da die Maskenfolie 1 plan ist.

**Patentansprüche**

1. Verfahren zum Stabilisieren einer aus einer Maskenfolie und einer, annähernd gleichen thermischen Ausdehnungskoeffizient wie diese besitzenden, rahmenartigen Halterung für diese Folie bestehenden Maske, die in einem Abbildungsgerät, im Betrieb abgebildet und dabei einer Wärmebeanspruchung durch ein Abbildungsmedium, z.B. Ionen-, Elektronen- oder Röntgenstrahlen, ausgesetzt wird, wobei die Maskenfolie für das Abbildungsmedium durchlässige Bereiche besitzt, dadurch gekennzeichnet, daß die Maskenfolie (1) in der rahmenartigen Halterung (2, 3, 4) stets spannungsfrei oder mit einer so geringen Vorspannung gehalten wird, daß durch die Vorspannung verursachte Verzerrungen von Strukturen in oder auf der Maskenfolie (1) für den Abbildungsprozeß vernachlässigbar sind, daß die Maskenfolie (1) mit ihrer rahmenartigen Halterung (2, 3, 4) in einem im Abbildungsgerät befindlichen Klemmrahmen (6, 7) geklemmt wird und daß im Betrieb des Abbildungsgerätes, also bei Erwärmung durch das Abbildungsmedium, dieser Klemmrahmen (6, 7) auf eine Temperatur erhitzt wird, welche die jeweilige Temperatur, die die Maskenfolie (1) im Betrieb des Abbildungsgerätes annimmt, übersteigt und dadurch auch die rahmenartige Halterung (2, 3, 4) auf diese Temperatur erhitzt wird, wobei das Übersteigen der Temperatur des Klemmrahmens (6, 7) über jene der Maskenfolie (1) nachgeregelt wird und jeweils nur soviel ausmacht, daß die Maskenfolie (1) auch bei Erwärmung plan und damit verzerrungsfrei bleibt, ohne daß unerwünscht hohe Spannungen auftreten.

2. Verfahren nach Anspruch 1, dadurch gekennzeichnet, daß vor dem Betrieb, also vor der Erwärmung durch das Abbildungsmedium, die Maskenfolie (1) in der rahmenartigen Halterung (2, 3, 4) mit einer Vorspannung entsprechend einer Dehnung von $10^{-5}$ bis $10^{-6}$ gehalten wird.

3. Verfahren nach Anspruch 1 oder 2, dadurch gekennzeichnet, daß die rahmenartige Halterung (2, 3, 4) auf eine Temperatur erhitzt wird, die jene Temperatur, die notwendig ist, um die Maskenfolie (1) planar zu halten, um 10° bis 20° übersteigt.

4. Verfahren nach einem der Ansprüche 1 bis 3, dadurch gekennzeichnet, daß bei Ausfall des Abbildungsmediums die Maskenfolie (1) durch Zufuhr eines Heizmediums aus einer zusätzlichen Wärmequelle auf eine Temperatur gebracht wird, die mindestens gleich der Temperatur der Maskenfolie (1) zum Zeitpunkt des Ausfalles des Abbildungsmediums ist, wobei das Heizmedium abhängig vom Temperaturabfall aktiviert wird.

## Claims

1. A process for the stabilisation of a mask consisting of masking foil and a frame-like mount for this foil of approximately similar thermal coefficient of expansion forming part of an imaging device and exposed in operation to thermal stress by means of an imaging medium, e.g. ion, electron or X-ray radiation, where regions of the masking foil are transparent to the imaging medium, characterised by the fact that the masking foil (1) in the frame-like mount (2, 3, 4) remains constantly free of tension or is held with such a small preliminary tension that the distortions in the structures in or on the masking foil (1) caused by preliminary tension are negligible for the imaging process, that the masking foil (1) with its frame-like mount (2, 3, 4) is clamped in a clamping frame (6, 7) incorporated in the imaging device and that when the imaging device is in operation, i.e. when the imaging medium raises the temperature, this clamping frame (6, 7) is heated to a temperature exceeding that reached by the masking foil (1) during the operation of the imaging device and the frame-like mount (2, 3, 4) is thus also raised to this temperature, where the extent to which the temperature of the clamping frame (6, 7) exceeds that of the masking foil (1) is adjusted and kept to a level where the masking foil (1) remains planar and thus distortion-free even when heated, without the occurrence of undesirably high tensions.

2. A process in accordance with claim 1 characterised by the fact that prior to operation, i.e. to heating by the imaging medium, the masking foil (1) is held in the frame-like mount (2, 3, 4) with a preliminary tension equivalent to an expansion of $10^{-5}$ to $10^{-6}$.

3. A process in accordance with claim 1 or 2 characterised by the fact that the frame-like mount (2, 3, 4) is heated to a temperature exceeding that necessary to maintain the planarity of the masking foil (1) by 10° to 20°.

4. A process in accordance with claim 1, 2 or 3 characterised by the fact that in the event of failure of the imaging medium the masking foil (1) is brought to a temperature at least equal to that of the masking foil (1) at the moment when the imaging medium failed by supplying a heating medium from a supplementary heat source, where the activation of the heating medium is dependent on the reduction in temperature.

## Revendications

1. Procédé pour stabiliser un masque constitué d'une feuille de masque et d'un support du genre masque pour cette feuille, support qui possède approximativement le même coefficient de dilatation thermique que cette feuille, le masque étant projeté dans un appareil de projection en fonctionnement et exposé alors à une sollicitation thermique par un agent de projection, par exemple des faisceaux d'ions, d'électrons ou de rayons X, et la feuille de masque possédant des régions laissant passer l'agent de projection, **caractérisé** en ce que la feuille de masque (1) est maintenue constamment dans le support du genre cadre (2, 3, 4) sans tension ou avec une prétension tellement faible que les distorsions, provoquées par la prétension, des structures présentes dans ou sur la feuille de masque (1) sont négligeables pour le processus de projection, en ce que la feuille de masque (1) est serrée avec son support du genre cadre (2, 3, 4) dans un cadre de serrage (6, 7) qui se trouve dans l'appareil de projection, et en ce que, pendant le fonctionnement de l'appareil de projection, donc lors de l'échauffement par l'agent de projection, ce cadre de serrage (6, 7) est chauffé à une température qui dépasse la température respective que prend la feuille de masque (1) pendant le fonctionnement de l'appareil de projection, de sorte que le support du genre cadre (2, 3, 4) est lui aussi chauffé à cette température, l'excédent de la température du cadre de serrage (6, 7) par rapport à celle de la feuille de masque (1) étant rajusté et étant chaque fois seulement d'une valeur telle que la feuille de masque (1) reste plane et donc exempte de distorsions même lors de l'échauffement, sans qu'apparaissent des tensions indésirablement élevées.

2. Procédé selon la revendication 1, **caractérisé** en ce qu'avant le fonctionnement, donc avant l'échauffement par l'agent de projection, la feuille de masque (1) est maintenue dans le support du genre cadre (2, 3, 4) avec une prétension correspondant à un allongement de $10^{-5}$ à $10^{-6}$.

3. Procédé selon la revendication 1 ou 2, **caractérisé** en ce que le support du genre cadre (2, 3, 4) est chauffé à une température qui dépasse de 10° à 20° la température qui est nécessaire pour maintenir la feuille de masque (1) plane.

4. Procédé selon l'une quelconque des revendications 1 à 3, **caractérisé** en ce qu'en cas de défaillance de l'agent de projection, la feuille de masque (1) est amenée, par l'apport d'un agent chauffant provenant d'une source supplémentaire de chaleur, à une température qui est au moins égale à la température de la feuille de masque (1) à l'instant de la défaillance de l'agent de projection, l'agent chauffant étant activé en fonction de la chute de température.

FIG.1

FIG.2

FIG.3

$S + \Delta S$

7